# EUROPEAN PATENT APPLICATION

(11) **EP 1 298 733 A1**
(43) Date of publication of application: **02.04.2003**
(21) Application number: 01810953.8
(22) Date of filing: 28.09.2001
(51) Int. Cl.: H01L 29/744

(54) **Turn-off high-power semiconductor device**

(71) Applicant: ABB Schweiz AG, 5400 Baden (CH)
(72) Inventor: Carroll, Eric, 5725 Leutwil (CH); Apeldoorn, Oscar, 5618 Bettwil (CH); Streit, Peter, 8967 Widen (CH); Weber, André, 4600 Olten (CH)
(74) Representative: ABB Patent Attorneys

(57) **Abstract**

A turn-off high power semiconductor device with the inner pnpn-layer structure of a Gate-Commutated Thyristor and a first gate on the cathode side has an additional second gate on the anode side, said second gate contacting the n-doped base layer and having a second gate contact. A second gate lead which is of rotationally symmetrical design and is disposed concentrically with respect to the anode contact is in contact with said second gate contact. Said second gate lead is brought out of the component and electrically insulated from the anode contact.

The rotationally symmetrical design of the second gate contact and gate lead leads to a considerable reduction in the loop inductance formed by the geometrical arrangement of the individual components in the second gate-anode circuit allowing fast reduction of charge carriers in the blocking transistor in synchronism with device turn-off via the cathode-side gate. The dual-gate semiconductor device can therefore be driven in a 'hard' mode with very steep and high gate pulses on either one or on both of the gates for both turn-on and turn-off and can achieve operating frequencies up to twice those of a conventional IGCT.

## Description

### Field of the Invention

This invention relates to the technical field of power electronics. It relates to a turn-off high-power semiconductor device according to the preamble of patent Claim 1.

### Background Art

In power electronics, the quest of the last ten years for fast turn-off high-power semiconductor switches has resulted amongst others in the IGCT (Integrated Gate-Comutated Transistor). The IGCT can be operated without complex external protective 'snubber' circuits due to a low inductance connection of the gate-unit to the gate-cathode circuit. The absence of snubbers eliminates snubber time-constants and losses, resulting in fast switching times.

US 5,345,096 describes such a snubber-less device (IGCT or Hard-Driven GTO) with a low-inductance interior design which can be driven in "hard mode", i.e. with very steep and high gate pulses for the turn-on and turn-off.

But the absence of snubbers also leads to significantly increased semiconductor turn-off switching losses. These turn-off losses, together with other device losses, e.g. conduction losses, limit the device's current and/or frequency capabilities.

Commonly used techniques for reducing the dynamic losses primarily rely on lifetime control, e.g. by irradiation or by the diffusion of impurity particles. Turn-off losses are effectively reduced but only at the cost of increased conduction losses. The origin of these losses lies in the large carrier concentration in the base of the blocking transistor. Attempts to reduce this charge by the above described techniques result in less conduction charge being available and hence in a redistribution of losses between conduction and switching rather than in an absolute loss reduction. These loss trade-offs result in application-specific component designs such that each design corresponds to minimal losses for only one application.

Lifetime control affects voltage rise-time, current fall-time and tail current during turn-off. In the absence of snubbers, the reduction of these three loss-generating components results in increased dv/dt and di/dt in the power electronic converter with potenially nefarious consequences with regards to load (motor) stresses and electromagnetic interference. The losses generated by the rise and fall times can be considered beneficial as they mitigate the above referenced consequences. The tail current losses, however, are wholly undesireable.

A more effective approach lies in the active removal of charge from the base of the blocking transistor at turn-off as is done with conventional bipolar transistors (three-terminal npn or pnp devices). In the case of a four-layer device such as the GTO, US 4,977,438 proposes an additional gate connection to the base of the blocking transistor section.

*Tsuneo Ogura et al., "High-Frequency 6000V Double* Gate *GTOs"*, *1993*, *IEEE Transactions on Electron Devices, Vol 40. No.3*, illustrates the substantial improvements that this technique allows for snubbered devices such as GTOs, which operate with parallel connected capacitors for dv/dt limitation.

The additional anode-side gate electrode is used to reduce high plasma density in the blocking transistor prior to turn-off thereby adding a further 30-50 µs delay. The resulting delay time of up to 80 µs makes the device too slow for practical power electronic conversion. The substantial loss reductions achieved with dual gate GTOs are eclipsed by the losses generated by the snubbers. The frequency capability of a dual gate GTO is determined more by the snubber losses and snubber time constants than by the semiconductor's switching losses, such that the overall benefits are small. A further disadvantage of the dual gate GTO is the fact, that in order to achieve optimal turn-on or turn-off, precise and current dependant timing of the gate pulse triggering is required.

All of the above described semiconductor devices are designed to have low gain pnp anode transistors to facilitate their turn-off. This design feature results in higher conduction losses than those of a conventional thyristor.

### Summary of the Invention

It is an object of the present invention to provide a turn-off high-power semiconductor device of the initially mentioned kind with an optimal loss reduction with no or negligible increase in delay time.

This object is achieved with a semiconductor device according to Claim 1.

It is particularly achieved by adding a second gate on the anode-side, said second gate contacting the n-doped base layer and having a second gate contact; and by providing a second low inductance gate lead which, in the case of high currents, may be preferentially of rotationally symmetrical design and in contact with said second gate contact, said second gate lead disposed, again in the case of high currents, preferentially concentrically with respect to the anode contact, being brought out of the component and being electrically insulated from the anode contact.

In the case of high currents, the rotationally symmetrical design of the second gate contact and gate lead leads to a considerable reduction in the loop inductance formed by the geometrical arrangement of the individual components in the second gate-anode circuit and hence to a fast and uniform reduction of the n-base charge. The inventive dual-gate semiconductor device can therefore be driven in a 'hard' mode like the above mentioned singel-gate snubberless turn-off device with very steep and high gate-pulses on either one or on both of the gates for both turn-on and turn-off.

Due to the hard-driven, anode-side second gate, the tail-current turn-off loss-component of conventional IGCTs can be eliminated without lifetime control techniques, resulting in substantially reduced snubberless turn-off losses of 30-70%.

The absence of lifetime control combined with a strong (high gain) anode structure reduces the conduction losses by 20 to 50%. It further allows low values of positive dv/dt and negative di/dt at turn-off which minimises filtering requirements at the equipment level.

The simultaneous reduction of switching and conduction losses allows turn-off semiconductors to be realised at higher voltages than at present, e.g. 10 kV instead of presently 6 kV.

The additional second gate can be used to reduce leakage currents by about 50% or to operate at higher temperatures. It further allows series connection without static sharing resistors.

The enhanced 'thermal budget' achieved with the combined above-mentioned advantages allows up to 100% higher operating frequencies for a given rating.

Unlike conventional dual-gate GTOs, the inventive device allows, via control of the gate current of one of the gates during turn-off, to modulate anode voltage. Voltage peaks, which occur in diodes or dual-gate elements whenever currents suddenly "snap-off", can therefore be controlled or absorbed.

The inventive device further allows near optimal turning-on and turning-off with synchronous triggering of both gates without complex timing patterns and without knowledge of the conduction current of the device.

Further embodiments emerge from the depending claims.

### Brief Description of the Drawings

A more complete appreciation of the invention and many of the attendant advantages thereof will be readily obtained as the same becomes better understood by reference to the following detailed description when considered in connection with the accompanying drawings, wherein:
- Fig. 1: schematically shows a sectional view of a semiconductor device in accordance with the invention, with a cathode-side first gate and an anode-side second gate,
- Fig. 2: shows a symbol of the semiconductor device of Fig. 1,
- Fig. 3: shows an equivalent circuit of the semiconductor device of Fig. 1,
- Fig. 4: shows a sectional view of an exemplary embodiment of the semiconductor device of Fig. 1, comprising an annular first gate contact and an annular first gate lead brought out between insulating housing and cathode contact and an annular second gate contact and an annular second gate lead brought out between insulating housing and anode contact;
- Fig. 5: shows the semiconductor device of Fig. 4 with a supply conductor of the gate-cathode circuit in the form of a strip conductor and a supply conductor of the gate-anode circuit in the form of a strip conductor;
- Fig. 6: shows a view on the semiconductor device of Fig. 5 with a cathodeside gate unit and an anode-side gate unit in a stack of four semiconductor devices,
- Fig. 7: shows another exemplary embodiment of the semiconductor device of Fig. 1, comprising an annular first gate contact and an annular first gate lead brought out laterally through the insulating housing and an annular second gate contact and an annular second gate lead brought out laterally through the insulating housing;
- Fig. 8: shows a diagram with turn-off characteristics of the semiconductor device of Fig. 1, with the first and second gate switched simultaneously, without actively extracting charge over the second gate,
- Figs. 9 and 10: show diagrams with turn-off characteristics of the semiconductor device of Fig. 1, with the first and second gate switched simultaneously, with the second gate actively extracting charge,
- Fig. 11: shows a diagram with turn-off characteristics of the semiconductor device of Fig. 1 when both gates are switched simultaneously and when the second gate is pre-triggered, and of differently irradiated standard IGCTs, and
- Fig. 12: shows a diagram with turn-off characteristics of a conventional low on-state IGCT and of a semiconductor device of Fig. 1 with similar on-state and silicon thickness.

### Description of the Preferred Embodiments

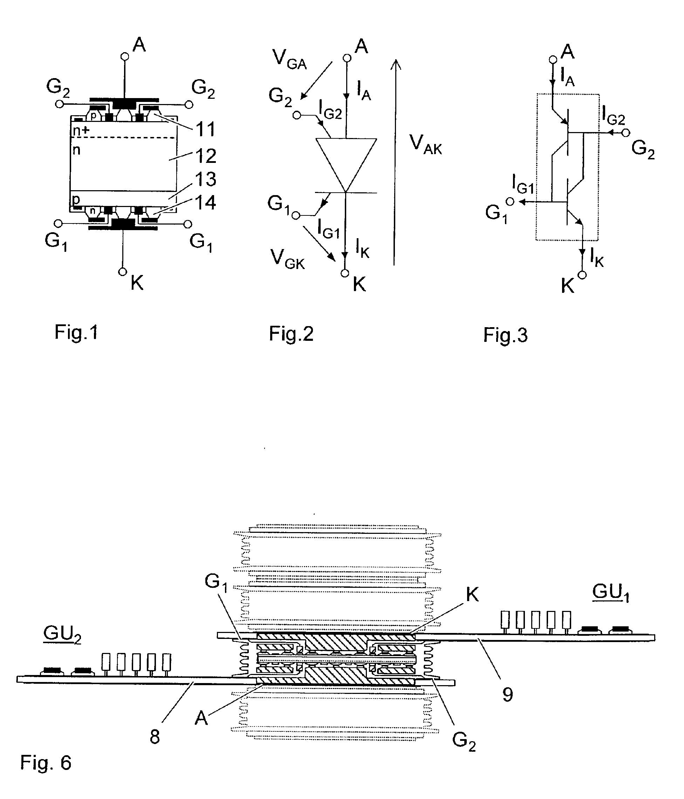

Referring now to the drawings, wherein like reference numerals designate identical or corresponding parts throughout the several views, Fig. 1 shows, schematically and in section, a semiconductor device in accordance with the invention.

The inventive semiconductor device, in this description furthermore referred to as Integrated-Gate Dual-Transistor (IGDT) has the basic inner structure of an Integrated Gate-Commutated Thyristor (IGCT), the semiconductor device used in the above-described IGCT.

The semiconductor substrate 1 of the IGDT consists of a sequence of four differently doped layers between an anode-side anode electrode 3 and a cathode-side cathode electrode 4:
- an outer p-doped anode layer 11 on the anode-side,
- an inner n-doped base layer 12, which comprises besides the normally doped n-doped layer a more heavily doped buffer layer which is close to the anode layer 11,
- an inner p-doped base layer 13 and
- an outer n-doped cathode layer 14 on the cathode-side.

Like the IGCT, the IGDT has a cathode-side electrode 6 of a first gate G₁ on the inner p-doped base layer 13.

As an added feature however, the IGDT has an electrode 5 of a second gate G₂ placed on the inner n-doped base layer (actually on the n-buffer layer).

The outer layers 11 and 14 are separated from the gate electrodes by a mesa structure as schematically shown in Figs. 1, 4, 5 and 7.

In order to increase dielectrical strength the first and second gate electrodes 6 and 5 are covered with a thin insulation layer, which is shown in Fig. 1.

Fig. 2 shows a proposed symbol for the IGDT, with four electrodes, an anode A, a cathode K and two gates G₁ and G₂. Anode-cathode voltage V_{AK}, first and second gate voltages V_{GK} and V_{GA}, anode current I_{A} and first and second gate currents I_{G1} and I_{G2} will be referred to in this description as shown in Fig. 2 with polarities, as indicated by the arrows, corresponding to the "off' or blocking state of the IGDT . Under these conditions, the voltages assume their maximal values and the currents their minimal or leakage values. The gate voltages in this state, reverse bias the base-emitter junctions of the two transistors of Fig. 3 and are hence considered negativeand the resulting currents are also negative.

Fig. 3 shows an equivalent circuit of the IGDT with its two gates and the anode-side pnp-transistor and cathode-sided npn-transistor. Anode-side the IGDT has a strong (high-gain) pnp-transistor which leads to reduced conduction losses.

In relation to its housing, the semiconductor device has many features which are already known from the "press pack" housing which has been introduced into the technology. A central constituent is a stack of various plates which, in an exemplary embodiment, may be disks. Pressure is applied to both sides of said stack. This stack is known in this manner, per se.

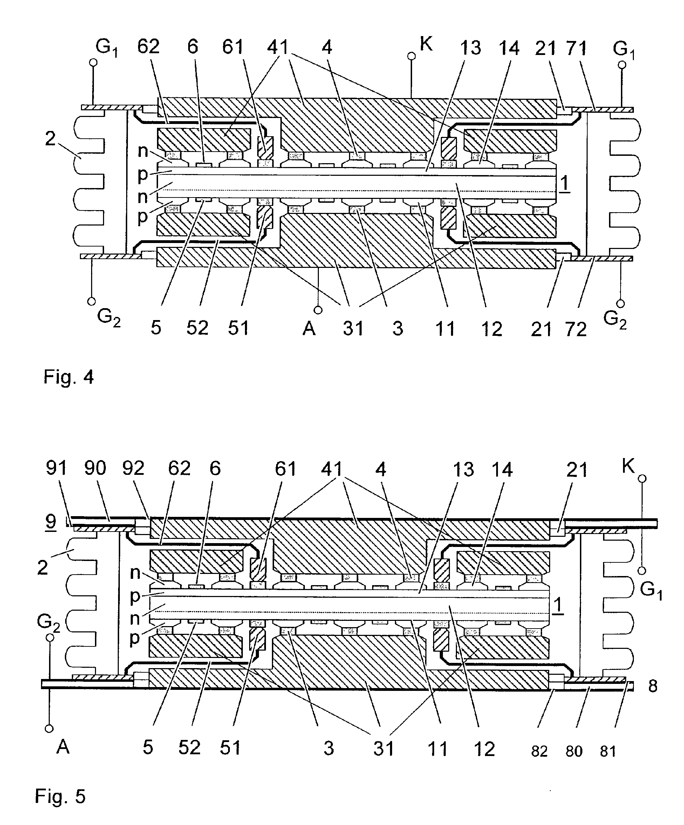

As shown in a first exemplary embodiment in Fig.4, the stack comprises the semiconductor substrate 1 which is disposed in the center and which is normally manufactured from Si and contains the above-described active part of the component.

To increase the dielectric strength, the semiconductor substrate is provided with an edge passivation. The semiconductor substrate 1 is contacted on the cathode side by a disk-shaped cathode contact 41 and on the anode side by a likewise disk-shaped anode contact 31, which are both normally composed of Cu. The cathode connection K is made via the cathode contact 41 and the anode connection A via the anode contact 31. To improve thermal cycling capability, Molybdenum disks may be provided between semiconductor Substrate 1 and the contacts 41 and 31, which disks compensate for the difference in thermal expansion between Si and Cu. In this connection, the semiconductor substrate may be joined to one of the Mo disks by a material joint or may be held between the disks by pressure alone (so-called "free-floating silicon" technology).

The stack comprising these disks is concentrically disposed in an annular insulating housing 2 which is preferably composed of a ceramic and may be provided with circumferential grooves on the outside to creepage distance. The insulating housing is normally provided at both ends with a flange (not shown) which is designed as a sheet-metal ring and is joined to the ceramic of the housing by a metal/ceramic joint. Joined to the flanges by a material joint (soldered, welded or the like) are a first and second lid 71 and 72 which are also annular and are composed of a metal sheet.

On the cathode side, the first lid 71 is joined to the associated first flange by a material joint. Its inner edge does not, however, extend to the cathode contact 41 but terminates at an insulating ring 21, which is preferably composed of a ceramic and is concentrically disposed around cathode contact 41. The insulating ring itself is then joined to the cathode contact by a further joining ring (not shown) made of sheet metal. Cathode contact 41, joining ring, insulating ring 21, first lid 71 and first flange thus form the hermetic (gastight) termination of the housing on the cathode side. The insulating ring 21 insulates the first lid 71 electrically from the cathode contact 41. This provides the possibility of using the first lid 71 as gate connection of the cathode-side first gate G₁. For this purpose, the semiconductor substrate 1 is designed in such a way that the access to the first gate electrode 6 can be made by an annular first gate contact 61, which either concentrically surrounds the cathode contact, or, as shown in Fig. 4, is embedded in an insulated manner by means of an insulating material between an outer annular cathode contact and an inner, disk-shaped cathode contact. The first gate contact 61 is connected in an electrically conducting manner to the first lid 71 via a likewise annular first gate lead 62. The first gate lead 62 is preferably made of sheet metal and is designed so that it runs as close as possible to, the cathode contact 41 and is firmly joined at that point (for example by a cold weld) to the inside of the first lid 71.

On the anode side, the electrode 5 of the second gate G₂ is likewise connected via a second gate contact 51 and a second gate lead 52 to the second lid 72.

Fig. 5 shows, that if the edges of the housing, i.e. the lids 71 and 72, are designed in such a way that soldering becomes possible, the component can be connected on both sides directly to an extremely low-inductance strip conductor 8 and 9. This technique has been introduced with the IGCT. Such strip conductors 8 and 9 comprise a sufficiently thick insulating sheet (printed circuit board) 80 and 90, in particular of a polyimide, which are provided on both sides with a metallization 81 or 82 and 91 and 92, preferably of Cu.

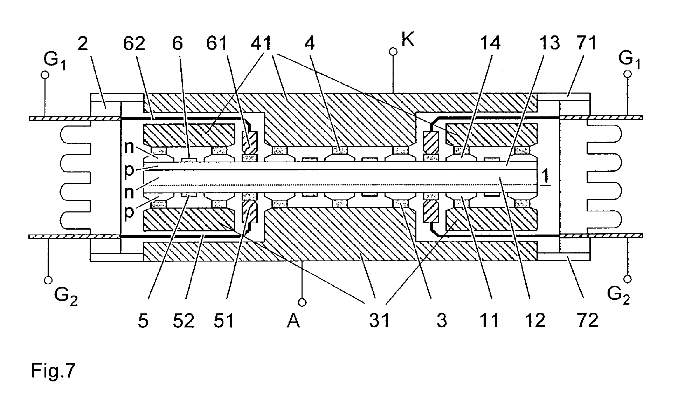

On the cathode side, the strip conductor 9 covers the entire surface of the cathode side of the component and consequently also finishes up between the cathode contact 41 and an anode contact of another device in a stack according to Fig. 6. In order to avoid difficulties with the insulating sheet 90 in the region of the cathode contact 41, the insulating sheet and the second metallization 92 are removed in this region. In this way, only the first (upper) metallization 91 is located atop of the cathode contact 41 and is used as cathode connection K. The second (lower) metallization 92 is connected in an electrically conducting manner to the first lid 71 by means of a solder joint and is used as first gate connection G₁.

On the anode side, the strip conductor 8 covers the surface of the component likewise.

Fig. 6 shows an IGDT with its two gate units GU₁ and GU₂ on the strip conductors 9 and 8 in a series connection of four IGDTs in a press-stack.

Fig. 7 shows another exemplary embodiment of the inventive semionductor device. First and second gate leads 62 and 61 are brought out of the component lateraly through the insulation housing 2. Double-layered strip conductors can also be connected to cathode, anode and first and second gate contacts just like in the aforementioned exemplary embodiment.

As known from the IGCT, the redesign of the gate leads situated inside the housing and the use of strip conductors, make possible an extremely low-inductance connection between the component and associated gate units, with the result that a "hard" drive can now be achieved with a substantially lower circuit complexity.

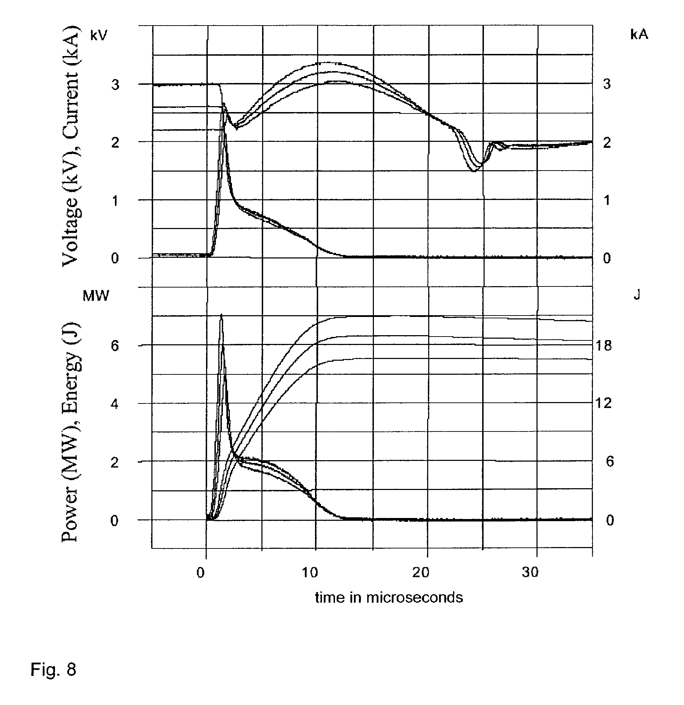

Several tests have been performed with IGDT devices with both 4.5 and 5.5 kV ratings and were compared with a standard 4.5 kV IGCT. Results of those test are shown in Figs. 8 to 12. The upper diagrams show anode-cathode voltage V_{AK} and anode current I_{A} as a function of time while the lower diagrams show Power and Energy in the IGDT as a function of time.,

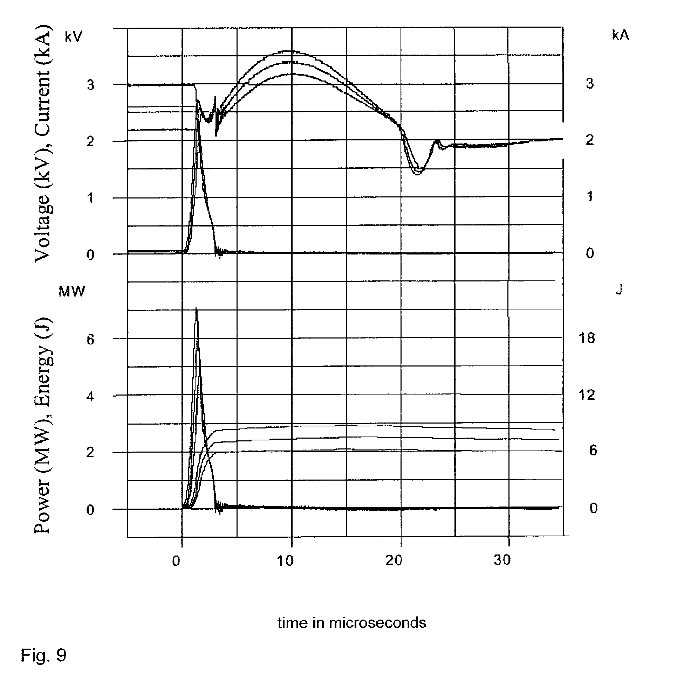

The IGDT device under test is turned-off by reverse-biasing the gate-cathode via the first gate unit GU₁ with a negative V_{GK}. At turn-off, the second gate unit GU₂ has an output voltage V_{GA} which is unidirectional for the purpose of these experiments, e.g. 0 V ≤ V_{GA} < 20 V, thereby reverse-biasing the gate-anode junction. At a time Δt prior to first gate G₁ turn-off, second gate unit GU₂ is switched on. In this way, charge carriers in the anode-side pn-junction are removed before switching off the complete device via the first gate unit GU₁. Fig. 8 shows the turn-off at 2 kV DC of a 4.5 kV symmetric IGDT device with the first and second gates G₁ and G₂ switched simultaneously (Δt = 0µs) with a G₂ voltage of 0V. In this experiment, the gate-unit merely shorts out the pnp transistor but does not actively extract n-base charge. The anode current is varied from 2.2 to 3 kA. Fig. 9 shows the results of the same test as for Fig. 6 but with V_{GA} = 20 V. The anode current is again varied from 2.2 to 3 kA. The anode gate unit is now able to eliminate the tail current reducing the turn-off loss from 21 Ws at 3 kA to 8.3 Ws, a 60% improvement.

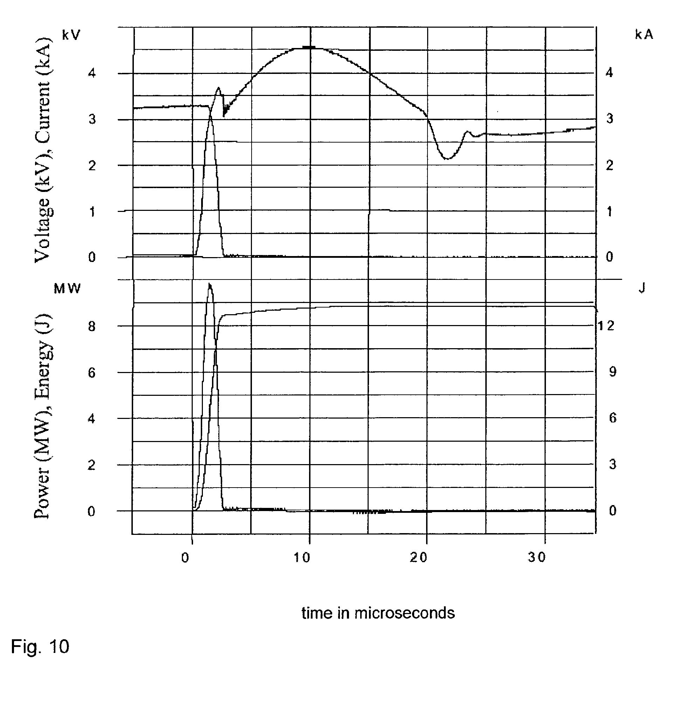

The same device as tested in Figs. 8 and 9 is successfully tested to 3.3 kA/2.8 kV in Fig. 10 (V_{GA}= 20V, Δt = 0µs). All the turn-off losses are generated in the voltage-rise and current-fall phases, the tail losses having been virtually eliminated. The device generates a measured loss of 13.5 Ws.

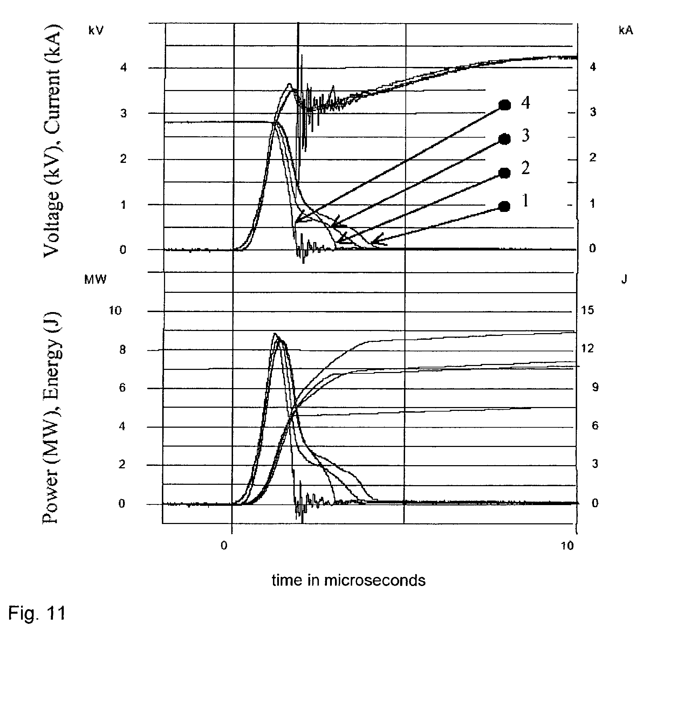

In Fig. 11, the turn-off waveforms of two differently irradiated standard IGCTs of 4.5 kV rating (1,2 in Fig. 11) are compared with those of a 5.5 kV IGDT when synchronously gated with Δt = 0µs (3 in Fig. 11) and when pre-triggered with Δt =1.5 µs (4 in Fig. 11). Although the 5.5kV device has a 20% thicker n-base, the comparison is made because, as a symmetrically structured device, it has a similar on-state voltage to one of the two asymmetrically structured IGCTs (2.55 and 2.61 V at I_{A}=4 kA, Tj=125°C for the 5.5 kV dual-gate and one of the 4.5 kV IGCTs respectively). Additionally, they have similar turn-off losses (about 10 Ws) in the case of the synchronously triggered dual-gate. Pre-triggering the dual-gate device by 1.5 µs reduces E_{OFF} by 30% to 7 Ws. Further pre-triggering is not possible as the anode current falls faster than linearly and provokes a "snap-off" as it goes to zero resulting in a high peak voltage (approx. 5.5 kV). Correcting the 30% loss improvement to allow for the thicker silicon used results in an effective improvement of 44% In a repetition of the experiment of Fig. 11, the anode current was lowered from 2.8 kA to 2.4 kA and the pre-trigger advanced to 2 µs before the over-voltage also reached 5.5 kV. This resulted in a 36% loss reduction (or 49% corrected).

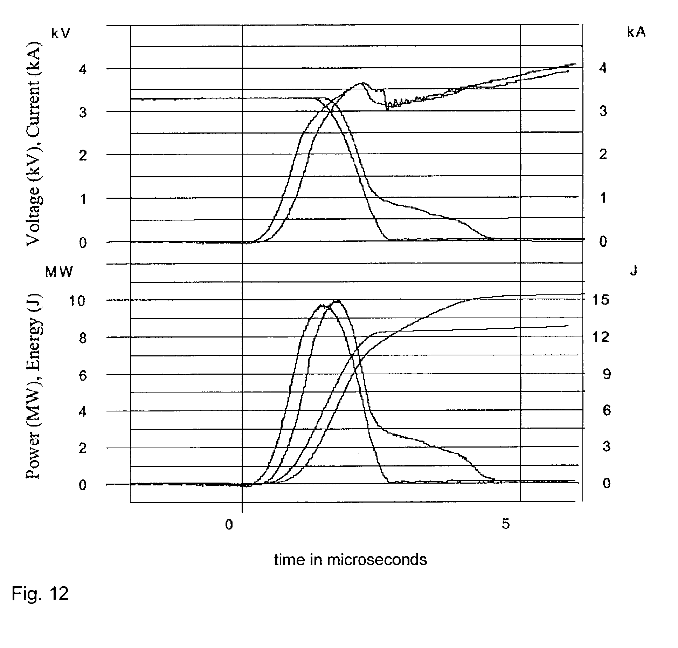

Fig. 12 shows a diagram with turn-off characteristics of a conventional low on-state IGCT and of an IGDT with similar on-state and silicon thickness.

Figs. 8 to 12 illustrate that the symmetric design allows very low on-state devices to be realized. The turn-off losses are effectively reduced by pre-triggering where:
- the silicon is thicker: Fig. 12 (18% improvement) vs Fig. 11 (30% improvement)
- the current is lower: (2.8 kA - 30% improvement) vs. (2.4 kA - 36% improvement)
- maximum pre-triggering can be exploited without snap.

Fig. 11 shows that higher voltage devices (5.5 vs. 4.5 kV) can be made with the same on-state voltage (2.55 ≈ 2.61 V at 4 kA/125°C) while still achieving a 30% loss reduction at 2.8 kV DC

Lifetime control (by irradiation) effects all three phases of the snubberless turn-off process:
Phase 1 - rising voltage at constant current
Phase 2 - falling current at (approx.) constant voltage
Phase 3 - tail current at (approx.) constant voltage.

The effect of de-saturating the anode pnp transistor prior to and during turn-off has been shown to completely eliminate the Phase 3 tail current losses. Advancing pre-triggering also has an action on the Phase 2 falling current at constant voltage, causing the anode current to fall so rapidly that over-voltage spikes are generated which ultimately exceed the device's blocking capability.

Pre-triggering is limited by the on-set of snap-off. Snap is aggravated by thin silicon and high currents indicating that this technology will be of greatest benefit at the higher voltages and their correspondingly lower currents.

The use of an anode-gate can *eliminate* the tail current of the conventional IGCT. In this respect, it is even more effective than lifetime control, which only *reduces* tail-losses while increasing conduction losses. Anode-gate control also offers the possibility of reducing rise and fall times (which has now become the dominant switching loss).

The symmetric structure is found to offer the greatest loss reductions and to allow even lower on-states than achieved by the transparent emitter of conventional IGCTs.

### List of Reference Signs

- 1: semiconductor substrate
- 11, 12, 13, 14: doped layers
- 2: Insulating housing
- 21: Insulating ring
- 3: Anode electrode
- 31: anode contact
- 4: Cathode electrode
- 41: cathode contact
- 5, 6: gate electrode
- 51, 61: gate contact
- 52, 62: gate lead
- 71, 72: Lid
- 8, 9: Strip conductor, circuit board (PCB)
- 80, 90: insulating sheet
- 81, 82, 91, 92: Metallization
- A: Anode
- G₁, G₂: Gate
- GU₁, GU₂: Gate Units
- I_{A}, I_{K}, I_{G1}, I_{G2}: Currents
- K: Cathode
- V_{AK}, V_{GK}, V_{GA}: Voltages

## Claims

1. A turn-off high-power semiconductor device comprising,
- a semiconductor substrate (1), and
- an insulating housing (2), in which the semiconductor substrate (1) is being disposed between a cathode contact (41) on a cathode-side, and an anode contact (31) on an anode-side;
said semiconductor substrate (1) having a plurality of differently doped layers (11, ... , 14),
said plurality of differently doped layers (11, ... , 14) defining the inner structure of a gate-commutaded thyristor which can be turned off via a first gate (5) and comprising a four-layer sequence consisting of
- an outer layer on the anode-side which is a p-doped anode layer (11),
- a n-doped base layer (12),
- a p-doped base layer (13) and
- an outer layer on the cathode-side which is an n-doped cathode layer (14),
said first gate (5) being arranged on the cathode-side, contacting said p-doped base layer (13) and having a first gate contact (51), and
said first gate contact (51) being contacted by a first gate lead (52) of low inductance,
**characterized in, that**
a second gate (6) is arranged on the anode-side, contacting said n-doped base layer (12) and having a second gate contact (61), and **in, that**
said second gate contact (61) is contacted by a second gate lead (62) of low inductance.

2. Turn-off high-power semiconductor device as in Claim 1 ,**characterized in, that**
- said semiconductor substrate (1) and said cathode and anode contacts (41, 31) are disk-shaped,
- said insulating housing (2) is of annular design,
- the semiconductor substrate (1) is being disposed concentrically between the cathode contact (41) and the anode contact (31),
- pressure can be applied to the cathode contact (41) and pressure can also be applied to the anode contact (31),
- the cathode contact (41) is connected to one end of the insulating housing via a first lid (71) and the anode contact (31) to the other end of the insulating housing via a second lid (72), a hermetically sealed component being formed,
- said first gate contact (51) is of rotationally symmetrical design,
- said first gate lead (52) is of rotationally symmetrical design, is disposed concentrically with respect to the cathode contact (41), is brought out of the component and is electrically insulated from the cathode contact (41), and
- said second gate contact (61) is of rotationally symmetrical design, and
- said second gate lead (62) is of rotationally symmetrical design, is disposed concentrically with respect to the anode contact (31), is brought out of the component and is electrically insulated from the anode contact (31).

3. The semiconductor device as claimed in Claim 2, **characterized in, that**
- the first gate contact and the first gate lead are of annular design, the first gate lead being brought out of the component between the cathode contact and the insulating housing;
the first gate lead connects the first gate directly to the first lid; and
the first lid is electrically insulated from the cathode contact by an interposed insulating ring which concentrically surrounds the cathode contact; and/ or **in, that**
- the second gate contact and the second gate lead are of annular design, the second gate lead being brought out of the component between the anode contact and the insulating housing;
the second gate lead connects the second gate directly to the second lid; and
the second lid is electrically insulated from the anode contact by an interposed insulating ring which concentrically surrounds the anode contact.

4. The semiconductor device as claimed in Claim 3, **characterized in, that**
- to provide a first gate connection and a cathode connection a first strip conductor is provided which comprises an insulating sheet provided with a first and a second metallization on opposite sides;
said first strip conductor spanning the component on the cathode side, the second metallization facing the component;
said insulating sheet and the second metallization having been removed from said first strip conductor in the region of the cathode contact in such a way that the first metallization is in direct contact with the cathode contact and forms the cathode connection; and
said second metallization being electrically connected directly to the first lid and forming the first gate connection; and/ or **in that**
- to provide a second gate connection and an anode connection a second strip conductor is provided which comprises an insulating sheet provided with a first and a second metallization on opposite sides;
said second strip conductor spanning the component on the anode side, the second metallization facing the component;
said insulating sheet and the second metallization having been removed from said second strip conductor in the region of the anode contact in such a way that the first metallization is in direct contact with the anode contact and forms the anode connection; and
- said second metallization being electrically connected directly to the second lid and forming the second gate connection.

5. The semiconductor device as claimed in Claim 2, **characterized in, that**
- The insulating housing (2) is subdivided into an upper housing part, a middle housing part and a lower housing part and the first gate lead is brought out of the component between the upper and the middle housing part and the second gate lead is brought out of the component between the middle and the lower housing part.

6. The semiconductor device as claimed in Claim 2, **characterized in, that**
- the cathode contact is subdivided into an inner cathode contact disk and an outer cathode contact ring which surrounds the cathode contact disk concentrically at a distance;
the first gate contact is disposed in an insulated manner between the cathode contact disk and the cathode contact ring; and
the first gate lead is brought out of the component in an insulated manner between the cathode contact disk and the cathode contact ring, and/ or **in that**,
the anode contact is subdivided into an inner anode contact disk and an outer anode contact ring which surrounds the anode contact disk concentrically at a distance;
the second gate contact is disposed in an insulated manner between the anode contact disk and the anode contact ring; and
the second gate lead is brought out of the component in an insulated manner between the anode contact disk and the anode contact ring.
